# EUROPEAN PATENT SPECIFICATION

(11) **EP 1 716 201 B1**
(45) Date of publication and mention of the grant of the patent: **07.09.2016**
(21) Application number: 05726406.1
(22) Date of filing: 16.02.2005
(51) Int. Cl.: C08K 5/00, C08L 101/00, C08L 63/00, C09D 163/00

(54) **FIRE RETARDANT COMPOSITIONS USING SILOXANES**
FLAMMWIDRIGE ZUSAMMENSETZUNGEN MIT SILOXANEN
COMPOSITIONS IGNIFUGES UTILISANT DES SILOXANES

(30) Priority: 18.02.2004 US 546026 P
(43) Date of publication of application: 02.11.2006
(73) Proprietor: Huntsman Advanced Materials (Switzerland) GmbH, 4057 Basel (CH)
(72) Inventor: JUN, Kathy, M., Cerritos, CA 90703 (US); LEWIS, Kathrine, J., Bell Canyon, CA 91307 (US)
(86) International application number: PCT/EP2005/001564
(87) International publication number: WO 2005/078012

(56) References cited:
- EP-A- 0 757 082
- EP-A- 0 808 874
- EP-A- 0 918 073
- EP-A- 1 026 204
- EP-A- 1 036 815
- EP-A- 1 049 152
- EP-B- 1 035 169
- EP-B- 1 188 794
- WO-A-03/072656
- US-A- 5 561 174
- US-A- 6 162 878
- US-B1- 6 177 489
- PATENT ABSTRACTS OF JAPAN vol. 016, no. 202 (C-0940), 14 May 1992 (1992-05-14) & JP 04 033961 A (TORAY DOW CORNING SILICONE CO LTD), 5 February 1992 (1992-02-05)

## Description

### Field of the Invention

The present invention relates to a fire retardant composition and to the use of this composition in the production of a cured laminate having self-extinguishing properties and good mechanical properties.

### Background of the Invention

The demand for plastic materials continues to grow in diverse industries such as automotive, aerospace, civilian, military and manufacturing, with applications such as home and office furniture and wall coverings, auto, rail, marine, and airplane interiors, cabinetry and casing, supports for electronic and computer systems and various components for machines and cookware. As a result of this growth, there is an increasing demand for fire retardant, smoke repressant plastic materials since accidental fires continue to extract a heavy toll on life and property. Unfortunately, thermoplastic and thermosetting resins, being organic in nature, are inherently combustible. This deficit has been addressed in the past, most notably by incorporating various halogen or phosphorous fire retardant additives into the plastic composition.

A fire retardant composition is a composition containing at least one component/compound/additive able to diminish or delay the combustion of the cured composition. A Fire retardant object can delay or diminish the flame (flame retardant), smoke (smoke repressant) and/or transmission of the combustion (fire screening). Preferably, a fire retardant composition adresses at least the aspect of flame retardancy.

However, the addition of such fire retardant additives generally detracts from the desirable mechanical properties of the plastic materials. For example, it is known that phosphorus-based fire retardant additives enhance the fire retardant character of various plastics when incorporated therein, but it has been found that the amounts of additive required severely degrade the strength and impact resistance of the compositions relative to virgin resins.

In addition, the toxicity of traditional fire retardant additives is a major concern. Prepregs, resin coated conductive foils, reinforced cores, and other substrates used in the manufacture of circuit boards typically include flammable resin components. Halogenated flame-retardants, such as bromine compounds, are added to these resins prior to use to produce flame retardant circuit board substrates and laminates. However, the use of halogen containing flame-retardant compounds in circuit board substrate resin formulations produces hazardous problems when used circuit board components are disposed of in landfills since there is the possibility that the halogens may leach from the circuit board components into the environment.

As a result, global initiatives are banning the use of many commercially-available flame-retardant resin systems that contain halogenated compounds, such as pentabromodiphenyl ether, since it is classified as a persistent (bioaccumulating) organic pollutant. Similarly, the use of antimony compounds such as antimony trioxide, often used synergistically with halogenated flame retardants, is being restricted due to toxicity concerns.

It has been reported that silicone resins may be combined with fillers to produce low flammability composite materials. Chao et al., "Development of Silicone Resins for Use in Fabricating Low Flammability Composite Materials," 42nd International SAMPE Symposium, May 4-8, 1997. However, in contrast to well known organic resin-based composites, silicone composites are expensive and would be expected to have less desirable mechanical properties. In general, silicones are not readily compatible with organic resins. Accordingly, there exists a need in the art to find silicone resins that are compatible with low viscosity engineering resins for use in the production of composite materials.
WO 03/072656 relates to a solid moulding composition which uses a mixture of silicone resins characterised by low melt viscosity [eg less than 10,000 mPasec-1 at 100C]. These are still paste like materials which require excessive heat to cause flow.US6177489 relates to melt mixed moulding compositions comprising epoxies, phenolic cure agent, silica and organosiloxane. EP1188794 relates to melt mixed mouldable composition comprising a thermoplastic resin, metal hydroxide, and a mixture of organosiloxanes.EP0918073 , and EP 1026204 likewise relates to melt kneaded mouldable composition comprising a synthetic resin having an aromatic group and 01 to 10 parts by wt siloxane compound.
EP 0806874 relates to a composition comprising as a base resin polyorganosiloxane with alkenyl groups.

There exists a need in the art for plastic materials and adhesive resin formulations that have a high degree of fire retardancy while still being easily processed and that retain good mechanical properties without placing any reliance on the above mentioned conventional means to achieve fire retardant properties. By 'easily processed' is meant formulating liquid compositions which have low viscosities for machine dispensation of vacuum induced wetting. For example: best viscosity ranges for use in laminating and fiber wetting systems (low surface energy liquid spreading on higher surface energy fibers) is 500-10,000 mPa·s, most preferably 1000-5000 mPa·s at ambient temperatures, eg 25C or 50C. Higher viscosities as described in prior art, eg from compositions which require melt mixing, for example, would undoubtedly give greater freedom in formulating fire retardant compositions , as high levels of oligomeric/polymeric materials, with or without aromatic character, could be used, including inorganic materials. However such pasty or liquid, high viscosity compositions are not always suitable for applications such as prepregs or laminating resins where the manufacturing process involve use of a curable composition which is fluid at room temperature. Moreover, pasty compositions require a time and energy consuming, melt mixing step at elevated temperature to ensure proper mixing of the components. We have found that suitable low viscosity mixture can be usefully achieved preferably with high level of siloxanes compounds provided these have compatibility with the cure-able part of the compositions.
Furthermore, there is need for a fire resistant, halogen-free adhesive resin composition that produces circuit board substrate materials with high Tg's (glass transition temperatures), low Dk's (dielectric constants) and low moisture absorption properties.

The present invention relates to a fire retardant composition that is especially useful for producing cured laminates that are flame retardant, smoke repressant and have good mechanical performance without the use of halogen or antimony additives.

### Summary of the Invention

The present invention provides a fire retardant composition comprising (a) a monomer, oligomer or polymer, or any mixture thereof; (b) a compatible siloxane; and (c) optionally, an additional fire retardant additive, wherein the composition is in liquid form at 25 °C, and wherein component (a) is a mixture of epoxies selected from the group consisting of diglycidyl ethers of bisphenol A, diglycidyl ethers of hydrogenated bisphenol A, diglycidyl ethers of bisphenol F, diglycidyl ethers of hydrogenated bisphenol F, epoxy novolac, cycloaliphatic epoxies and tri-and tetra-functional glycidyl functional tertiary amines.

The present invention further provides a fire retardant composition comprising (a) a monomer, oligomer or polymer, or any mixture thereof; (b) a compatible siloxane; and (c) a fire retardant additive that is not a halogenated or antimony compound.

In another aspect, there is provided a process of producing a fire retardant laminate, the process comprising the steps of applying the fire retardant compositions described above to a substrate and curing or setting the composition and substrate to form a laminate.

An object of the present invention is to provide a fire retardant composition that produces or can be cured to produce polymers or polymer-based materials, for example, polyamides, nylons, polyesters, epoxy resins, phenoxy resins, ABS combinations, polyethylenes, polypropylenes, polyurethanes, polyureas, polyacrylates/polymethacrylates (homo- and copolymers), polystyrenes, polychlopropene, phenolics, silicones, silicone rubbers and copolymers and combinations of polymers.

Another object of the present invention is to provide a fire retardant composition that is particularly useful as a laminating resin for aerospace (including satellite), auto, marine, electronic, and certain architectural industries.

A further object of the present invention is to provide a cured article made from the flame retardant compositions described above.

Yet a further object of the present invention is to provide a method for combining a non-combustible substrate, usually inorganic fibers such as glass fibers, with the fire retardant compositions described above to form fire retardant composites that are useful as adhesives, sealants, coatings, and in laminated composites for flooring, ceiling, or wall coverings, as well as moulded laminar composites (e.g. for auto, rail, aerospace, and certain architectural applications).

### Detailed Description of the Invention

The composition of the present invention may be used to produce fire retardant materials with self-extinguishing properties and good mechanical properties.

### MONOMER, OLIGOMER OR POLYMER, OR ANY MIXTURE THEREOF

Preferably, the mixture of epoxies according to component (a) will be one that is useful in the manufacture of adhesive resin coated metal foils. The fire retardant composition may include a combination of two or more monomers, oligomers or polymers having the same or different molecular weights and degrees of functionality. Such combinations can be advantageously combined in a formulation that results in a cured resin having a high Tg (glass transition temperature) and low Dk (dielectric constant).

The base resin is liquid at 25C. This permits to form fire retardant curable composition at room temperature.

The composition does not contain a base resin in solid form, such as, for example, crystalline epoxies. Indeed these are not as easy to process by requiring melt mixing and tend to provide pasty-like or solid curable compositions.

The monomer, oligomer or polymer, or mixture thereof preferably has a viscosity range from about 900 to 20,000 mPa·s, more preferably from about 1200 to about 12,000 mPa·s. All viscosity values given in the specification are measured at 25C unless another temperature is specifically mentioned.

Examples of useful monomers, oligomers or polymers include bis-phenol epoxy resins, and epoxidised phenolic novolac resins. More preferably, the epoxies according to component (a) contain aromatic groups.

Most preferably, the mixture of epoxies according to component (a) is of viscosity less than 20,000 mPa·s, most preferably less than 10,000 mPa·s. Preferably, it has a low molecular weight (300-1000).

The most highly preferred is a mixture of low viscosity bis-glycidyl epoxies of bisphenol A and bisphenol F, without reactive-epoxy diluents, for maximum cured laminate strength.

The fire retardant composition of the present invention comprises about 40 to about 85 percent by weight of the monomer, oligomer or polymer, or mixture thereof.

### COMPATIBLE SILOXANE

The compatible siloxane of the present invention is a siloxane that is thoroughly miscible with the above-described the base resin or within a liquid solution of the base resin. Compatible siloxane can be solid or liquid at room temperature. In one embodiment, compatible siloxane in solid form is mixed within a liquid base resin. Preferably, siloxanes are so thoroughly miscible if, when mixed with the base resin, they produce a transparent mixture. Transparent mixtures preferably have a single Tg.

Compatible siloxanes may be of low or high molecular weight. Low molecular weight siloxanes are more easily miscible with the base resin, however high molecular weight siloxanes tend to give better fire retardant properties. High molecular weight compatible siloxanes may be selected on the basis of functional groups that aid in making the molecule thoroughly miscible with the base resin. For example, it has been discovered that phenyl rings or epoxy-containing side chains on the silicon atoms of the siloxane backbone tend to increase its compatibility with aromatic monomers such as bisphenol A epoxies, bisphenol F epoxies and blends thereof. Examples of epoxy-compatible siloxanes are those in which the silicon atom of the repeating unit(s) is mono- or di-substituted by a phenyl group(s), or is methyl, phenyl di-substituted, or methyl substituted, phenyl di-substituted (e.g. glycidylpropopylphenyl), or methyl, glycidyl-propyl, di-substituted, provided in the latter case that the siloxane oligomer is not too high in molecular weight to be compatible with the base resin.

Specific examples of epoxy-compatible siloxanes are aliphatic pendant epoxy-functional siloxanes (e.g. GP-611), which are compatible with bisphenol A epoxy resin (e.g. DER 330) and cycloaliphatic epoxy (e.g. ERL 4221). Diepoxy silicone (e.g. SIB 1115), oligomeric phenylsilsesquioxane siloxane (e.g. Dow Corning 217 flake), and oligomeric phenyl/methylsilsesquioxane siloxane (e.g. 3074) are compatible with bisphenol A epoxy (e.g. DER 330). Table A provides descriptive information for the above-mentioned epoxy-compatible siloxanes.

**TABLE A**

| Product | Manufacturer | | Structure |
|---|---|---|---|
| GP-611 | Genesee | Epoxy functional | 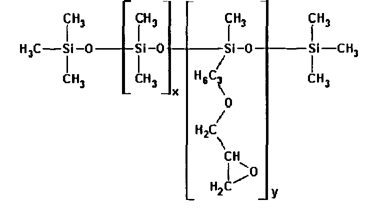 |
| | Polymers | X=0 | |
| | Corp | Y=40 | |
| | | MW=4,300 | |
| | | EEW¹=181 | |
| SIB 1115 | Gelest | MW=360 | 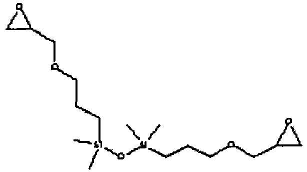 |
| 217 flake | Dow Corning | Oligomeric silsesquioxane | 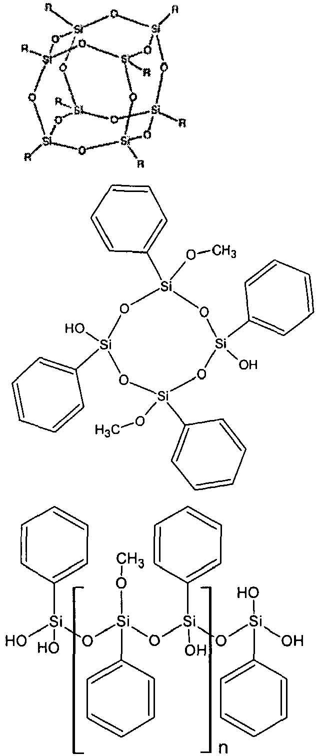 |
| | | Solid | |
| | | MW: 1500-2500 | |
| | | Phenyl/methyl ratio: 100/0 | |
| | | Silanol Hydroxy: 6% | |
| | | SiO_{2:}47% | |
| | | Proprietary | |
| | | 217 flake is similar to these structures, but not fully crosslinked. It comprises some cage structures, some 8-membered alterating Si-O-Si-O atom ring structures with phenyl (R) and -OH or-OCH₃ on each Si in addition to the two O's to which each is bonded in the ring or chain, and further and less polymerized straight-chain oligomers. | |
| 3074 | Dow Corning | MW= 100-1500 | 3074 flake is similar to the structures above, but contains both phenyl and methyl substitution on the Si atoms, and again is an oligomeric mixture, not fully crosslinked. |
| | | Phenyl/methyl= 50/50 | |
| | | Methoxy= 15-18% | |
| | | SiO₂= 54% | |
| | | | 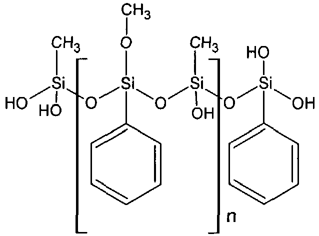 |

| | | | |
|---|---|---|---|
| ¹ EEW means epoxy equivalent weight. | | | |

In addition, when the compatible siloxane/base resin composition is used to make composite materials having a fibrous or other suitable substrate, the composition will be selected so that it readily wets out the desired substrate. For example, it has been discovered that the presence of hydroxy groups on the compatible siloxane yields particularly good wetting and mechanical coupling to fiber-glass reinforcing fabric, which leads to superior mechanical strength in a cured laminate.

Preferably, when aromatic base resins are used in the present invention, the compatible siloxane will be a polyphenylsiloxane. This is a polysiloxane in which the silicon atom of the repeating unit(s) is mono- or di-substituted by a phenyl group(s).

Furthermore, the polyphenylsiloxane of the present invention may be epoxy functional. Preferably, when glass fiber composites are contemplated, the polyphenyl or epoxy-functional polyphenyl siloxane of the present invention will be hydroxy functional. Most preferably, in these applications, the siloxane of the present invention is hydroxy functional polyphenylsiloxane.

Also preferred is a hydroxy functional polyphenylsiloxane that is at least 40 mol percent mono-substituted by phenyl groups or substituted phenyl groups and comprises about 30 to about 70 percent by weight of silicon dioxide and silanol hydroxy groups. Preferably, the silanol hydroxy is greater than about 2 percent. Particularly preferred is a hydroxy functional polyphenylsiloxane that comprises about 50 percent by weight of silicon dioxide and silanol hydroxy groups. Highly preferred is a hydroxy functional polyphenylsiloxane that comprises 100 mol percent of monophenylsiloxane and about 47 percent by weight of silicon dioxide and about 6 percent by weight of silanol hydroxy groups.

The most highly preferred hydroxy functional polyphenylsiloxane is an oligomeric phenylsilsesquioxane siloxane, e.g. Flake 217 manufactured by Dow Corning. Flake 217 comprises an oligomerized 8-membered, alterating Si-O-Si-O atom ring structure, and some 20-membered cage structures, with phenyl or substituted phenyl groups and hydroxy groups on the silicon atoms in addition to the two oxygen atoms to which each silicon atom is bonded in the rings and cages, as well as further and less polymerized straight chain siloxane oligomers (see Table A).

The fire retardant composition of the present invention preferably comprises about 2 to about 50 percent by weight of the compatible siloxane.

### FIRE RETARDANT ADDITIVE

The fire retardant composition of the present invention preferably comprises an additional fire retardant additive other than siloxane. The additive may be a phosphorus compound, silica nano particles, or any other traditional fire retardant additive other than halogenated or antimony compounds. Preferably the fire retardant composition does not comprise more than trace amounts of halogenated resin components, halogenated additives or antimony trioxid

Conventional phosphorus-based fire retardant compounds having a boiling point, or decomposition point, of at least about 180° C are suitable for the present invention. The decomposition point of at least about 180° C is required for applications where heat curing is used, since the phosphorus compound must be thoroughly compounded with the monomer, oligomer or polymer, or any mixture thereof, and must not volatilize or degrade at process temperatures.

The phosphorus compound of the present invention may be selected from such compounds as red phosphorus; ammonium polyphosphates; oligomeric alkyl or aryl phosphonates (e.g. of dihydric phenols); triaryl phosphates, such as tricresyl phosphate; alkyl diphenyl phosphates, such as isodecyl diphenyl phosphate and 2-ethylhexyl diphenyl phosphate; triphenyl phosphates, such as triphenyl phosphate; phosphonitrilics; phosphonium bromides; phosphine oxides; reactive organophosphorus monomers, and various phosphorus-containing diols and polyols. Further details relating to these materials may be found in the section by E. D. Weil in The Encyclopedia of Chemical Technology, vol. 10, 3rd Edition, pages 396-419 (1980), herein incorporated by reference.

Preferably, the phosphorus compound is a liquid organo phosphate or phosphonate compound. Most preferably, the phosphorus compound of the present invention is a liquid phosphonate ester compound comprising greater than about 20 percent by weight of phosphorus and greater than about 50 percent by weight of phosphorus oxide.

Alternatively, the fire retardant additive may be silica nano particles. An exemplary silica nano particle is Nanopox XP 22/0525, manufactured by Hanse Chemie.

The fire retardant composition of the present invention does not comprise more than trace amounts of halogenated resin components, which may be residual from the original epoxy synthesis process.

The fire retardant composition of the present invention may comprise up to about 40 percent by weight of an additional fire retardant additive other than siloxane.

### OTHER COMPONENTS

The fire retardant composition of the present invention may further comprise a curing agent such as an amine hardener, e.g. aliphatic or cycloaliphatic amines and adducts, adducts with bisphenol or other hydroxy functional catalysts, amidoamines, imidazoline adducts, an anhydride, cyanoguanidine, polyamides and mixtures thereof. It is highly preferred that the fire retardant composition be curable at room temperature with work life/gel time controlled by the choice of hardener. Heat curing may also be used, at preferably less than 100°C.

Other additives include a mixture of a polyisocyanate having at least two isocyanate groups with a polyol having at least two hydroxyl groups or a carboxylic acid, and a mixture of acrylates or methacrylates with an appropriate initiator. Additives having functionalities equal to 2 are highly preferred mixed with smaller amounts of additives having a functionality that is greater than 2. Tougheners such as polytetrahydrofuran-diol or -triol and related polyglycol-diols can also be used with isocyanates to create flexible urethane segments in order to impart toughness in the laminated products made from the compositions described herein.

Preferably, the fire retardant composition of the present invention will include from about 10 to 40 wt % of a halogen- and antimony-free flame retardant additive and from about 60 to 90 wt % of one or more monomers, oligomers, or polymers, or any mixtures thereof. More preferably, the fire retardant composition of the present invention will include from about 10 to about 25 wt %, most preferably from about 15 to about 25 wt %, of one or more halogen- and antimony-free flame retardant additives with the remainder being one or more monomers, oligomers, or polymers, or any mixtures thereof.

### COMPOSITE METHODS

The present invention provides a method of producing a fire retardant composite comprising the steps of applying the fire retardant composition to a substrate and curing or setting the composition and substrate to form a composite.

A method of producing a fire retardant laminate comprises the steps of (1) mixing the fire retardant composition of the present invention with an appropriate amount of a hardener; (2) assembling multiple plies of a substrate by (a) laying down one ply; (b) applying component (1) onto the surface of the ply and spreading it over the entire area; (c) placing another ply on top of the preceding ply; (d) repeating steps (a)-(c) until all plies have been laid down; and (3) curing the multi-ply laminate.

A second method of producing a fire retardant laminate comprises the steps of (1) mixing the fire retardant composition of the present invention with an appropriate amount of a hardener; (2) assembling multiple plies of a substrate into a stack; (b) applying component (1) to the stack; (c)

Other fabric/resin infusion methods such as vacuum-assisted resin transfer molding (VARTM) can be used with the fire retardant composition of the present invention. In the VARTM process, the fire retardant composition of the present invention is mixed with an appropriate amount of a hardener. A stack of dry fibreglass or other fabric is placed in a mold fitted with a flexible, vacuum tight top, a vacuum valve on one end, and a liquid resin reservoir valve on the other. The mold is evacuated prior to opening the resin valve. After the resin valve is opened and the resin is allowed to flow into the evacuated fiber stack-filled cavity, vacuum pumping is continued to 'assist transfer of the liquid resin' through the evacuated fiber stack. Pumping is continued for a time after closing the resin valve to compact the fiber/resin structure to a maximum, void-free fiber content. The multi-ply laminate is thereafter cured.

The substrate in the foregoing methods, composites and laminates may be any substrate known in the art of composite materials. For example, the substrate may be fiberglass, carbon fibers, or carbon nanotubes. The method of laminating is usually carried out with the assistance of vacuum, although with low enough viscosity liquids, gravity and 'surface-tension'-only assisted lamination may be possible. The best viscosity ranges for use in laminating and fiber wetting systems (low surface energy liquid spreading on higher surface energy fibers) is 500-10,000 mPa·s, most preferably 1000-5000 mPa·s.

The present invention is directed to fire retardant compositions able to provide self-extinguishing properties for applications requiring low viscosity as laminating resins, adhesives, sealants, coatings, printed wiring boards, prepregs, composites with combustible or non combustible fibers such as glass fibers, Aluminium borate whiskers, granite fibers etc, and other fibers such as textile and carbon fibers. These compositions comprise a base resin and a compatible siloxane and, optionally, an additional fire retardant additive that is not a halogenated or an antimony compound

### EXAMPLES

Table 1 lists the components of Compositions 1-6. The numbers in Table 1 refer to the weight percent of each component based on the total weight of the fire retardant composition, which is cured with an amine hardener at ratios in the range of 100 parts of the fire retardant composition to 13-16 parts of the amine hardener. Compositions 3, 4 and 6 were prepared by first heating bisphenol A epoxy to about 95°C (203°F) while stirring. While high shear mixing, 217 flake was added slowly. Bisphenol A epoxy and 217 flake were mixed while heating until the 217 flake was completely dissolved, forming a liquid intermediate. The intermediate and all other components were then mixed at room temperature, or up to about 150°F, until a uniform mixture was obtained. All of the starting components of compositions 1, 2 and 5 were liquids and were simply mixed at ambient temperature, or up to about 150°F, until a uniform mixture was obtained.

**TABLE 1**

| Component Name | Composition 1 Control | Composition 2 | Composition 3 | Composition 4 | Composition 5 | Composition 6 |
|---|---|---|---|---|---|---|
| Epoxy | 62.00 | 62 | 63.75 | 65.75 | 59.3 | 68.06 |
| FR-001 (phosphonate) | 0.00 | 22.1 | 0 | 12.00 | 0 | 0 |
| Nano-silica from Nanopox XP 22/0525 | 0.00 | 0 | 0 | 0 | 24.8 | 13.68 |
| DE-71 PBDE | 22.10 | 0 | 0 | 0 | 0 | 0 |
| 217 siloxane | 0.00 | 0 | 21.25 | 11.25 | 0 | 3.66 |
| TCP | 15.00 | 15 | 14 | 10.00 | 15 | 13.6 |
| Nonylphenol | 0.45 | 0.45 | 0.45 | 0.45 | 0.45 | 0.45 |
| Epoxysilane | 0.45 | 0.45 | 0.45 | 0.45 | 0.45 | 0.45 |
| AF-4 | 0.00 | 0 | 0.1 | 0.10 | 0 | 0.10 |
| Total | 100 | 100 | 100 | 100 | 100 | 100 |
| % organic in Formula | 80.35 | 83.87 | 84.98 | 84.73 | 71.18 | 80.77 |
| | | | | | | |
| %SiOx | 0.15 | 0.15 | 11.41 | 6.11 | 24.95 | 15.79 |
| %POx | 3.87 | 15.99 | 3.61 | 9.16 | 3.87 | 3.51 |
| %Br | 15.63 | 0.00 | 0.00 | 0.00 | 0.00 | 0.00 |
| Total non-combustible | 19.65 | 16.13 | 15.02 | 15.27 | 28.82 | 19.30 |

### COMPOSITION 1

Composition 1 (the control) contains pentabromodiphenyl ether (PBDE), a brominated flame retardant. It has the following structure:

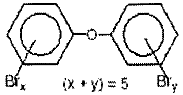

### COMPOSITIONS 3, 4 AND 6

Compositions 3, 4 and 6, shown above, comprise bisphenol A and bisphenol F epoxies and a siloxane having 100 mol percent of a monophenylsiloxane having about 47 percent by weight of silicon dioxide groups and 6 percent by weight of silanol hydroxy groups.

### COMPOSITION 4

Composition 4 is a low viscosity epoxy laminating resin. It comprises a phosphonate ester compound and an epoxy-compatible, fiberglass- and filler-wetting polyphenylsiloxane in order to achieve high compressive strength and flame retarding properties in a room-temperature curing, laminating resin blend. Composition 4 does not contain typical flame retardant additives, such as a brominated and/or chlorinated compound or antimony trioxide.

Table 2 lists the components of Composition 4 and some descriptive information regarding each component. The numbers in Table 2 refer to the weight percent of each component based on the total weight of the fire retardant composition. Table 3 provides further descriptive information for the components of Composition 4.

**TABLE 2**

| Component | Wt % | Chemical Name/ Description | Structure |
|---|---|---|---|
| Epalloy 8220 | 32.00 | Bisphenol F epoxy resin | |
| DER 330 | 33.75 | Bisphenol A epoxy resin | |
| 217 flake | 11.25 | Oligomeric silsesquioxane Solid | 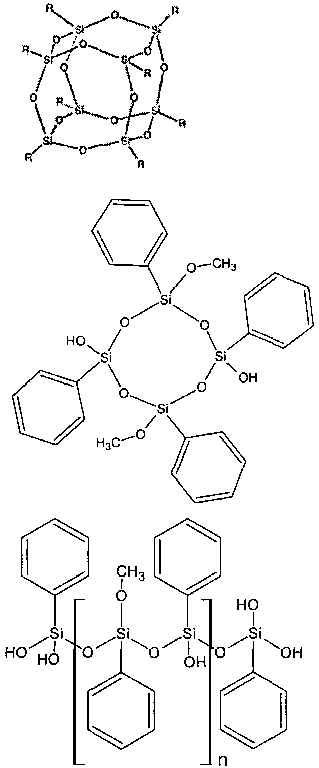 |
| | | MW: 1500-2500 | |
| | | Phenyl/methyl ratio: 100/0 | |
| | | Silanol Hydroxy: 6% | |
| | | SiO_{2:} 47% | |
| | | Proprietary | |
| | | 217 flake is similar to these structures, but not fully crosslinked. It contains some cage structure, some 8-membered alterating Si-O-Si-O atom ring structures with phenyl (R) and -OH or -OCH₃ on each Si in addition to the two O's to which each is bonded in the ring or chain, and further and less polymerized straight-chain oligomers. | |
| FR-001 | 12.00 | Phosphonate ester | Proprietary |
| | | P content = 21.5% | May be mix of aryl & alkyl substituted oligomeric phosphonate esters. |
| | | PO₃ content =∼55%. | |
| TCP | 10.00 | tricresyl phosphate | 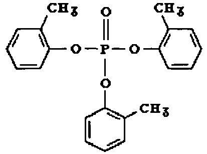 |
| nonylphenol | 0.45 | 4-nonylphenol | 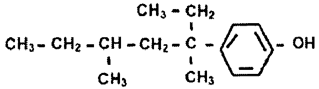 |
| Glymo | 0.45 | Glycidoxypropyltri-methoxysilane | 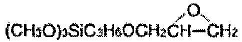 |
| AF-4 | 0.10 | Acrylate copolymer | |

**TABLE 3**

| Component | Function | Properties |
|---|---|---|
| Epalloy 8220 | Adhesion | Average epoxy functionality: 2.05 |
| | Low viscosity epoxy resin | EEW: 164-176 g/eq |
| | | Viscosity: 1,800-2,800 cP @ 25°C |
| DER 330 | Adhesion | EEW: 176-180 g/eq |
| | Low cost epoxy resin | Viscosity: 7,000-10,000 cP @ 25°C |
| 217 | Flame retardant | Solid |
| polyphenyl siloxane | Increases coupling between resin and fiberglass, while having compatibility with epoxy | MW: 1500-2500 |
| | | Phenyl/methyl ratio: 100/0 |
| | | Silanol: 6% |
| | | SiO_{2:} 47% |
| FR-001 | Flame retardant | Phosphorus content: 21.5% |
| | Easily blendable, Br-free liquid phosphonate ester | Viscosity: 7,000-10,000 cP @ 40°C |
| TCP | Diluent | |
| | Viscosity reducer, fiber wetting, has some phosphorus content | |
| nonylphenol | Additive | |
| | Low viscosity, wetting agent &/or reaction catalyst | |
| Glymo | Additive | |
| | Adhesion promoter, enhanced resin coupling with fiberglass and silica filler | |
| AF-4 | Additive | |
| | wetting agent, defoamer | |

### COMPOSITION 6

Composition 6 comprises a nano-silica dispersion in epoxy and an epoxy-compatible, fiberglass- and filler-wetting polyphenylsiloxane in order to achieve high compressive strength and flame retarding properties in a room-temperature curing, laminating epoxy resin blend. Composition 6 does not contain typical flame retardant additives, such as a brominated and/or chlorinated compound or antimony trioxide. Additionally, composition 6 does not contain phosphorous compounds and is therefore the most environmentally 'green' technology.

Table 4 lists the components of Composition 6 and some descriptive information regarding each component. The numbers in Table 4 refer to the weight percent of each component based on the total weight of the fire retardant composition. Table 5 provides further descriptive information for the components of Composition 6.

**TABLE 4**

| Component | Wt % | Chemical Name/Description | Structure |
|---|---|---|---|
| Epalloy 8220 | 36.55 | Bisphenol F epoxy resin | |
| DER 330 | 10.99 | Bisphenol A epoxy resin | |
| 217 flake | 3.66 | Oligomeric silsesquioxane | 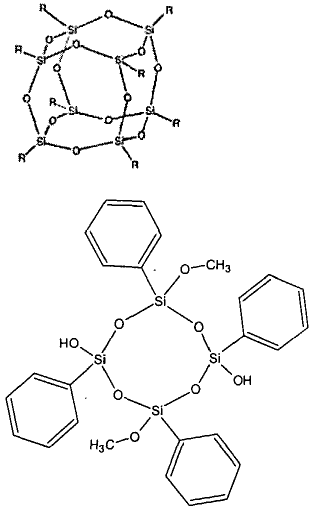 |
| | | Solid | |
| | | MW: 1500-2500 | |
| | | Phenyl/methyl ratio: 100/0 | |
| | | Silanol Hydroxy: 6% | |
| | | SiO_{2:} 47% | |
| | | Proprietary | |
| | | 217 flake is similar to these structures, but not fully crosslinked. It contains some cage structure, some 8-membered alterating Si-O-Si-O atom ring structures with phenyl (R) and -OH or -OCH₃ on each Si in addition to the two O's to which each is bonded in the ring or chain, and further and less polymerized straight-chain oligomers. | |
| | | | 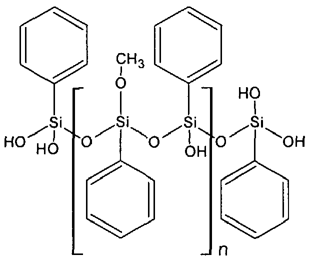 |
| Nanopox XP 22/0525 | 34.20 | Dispersion of nano-size silica in Bisphenol F epoxy resin | |
| TCP | 13.6 | tricresyl phosphate | 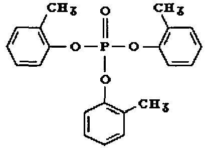 |
| nonylphenol | 0.45 | 4-nonylphenol | 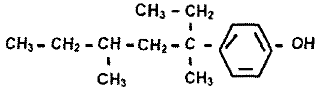 |
| Glymo | 0.45 | Glycidoxypropyltri-methoxysilane | 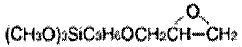 |
| AF-4 | 0.10 | Acrylate copolymer | |

**TABLE 5**

| Component | Function | Properties |
|---|---|---|
| Epalloy 8220 | Adhesion | Average epoxy functionality: 2.05 |
| | Low viscosity epoxy resin | EEW: 164-176 g/eq |
| | | Viscosity: 1,800-2,800 cP @ |
| | | 25°C |
| DER 330 | Adhesion | EEW: 176-180 g/eq |
| | Low cost epoxy resin | Viscosity: 7,000-10,000 cP @ 25°C |
| 217 polyphenyl siloxane | Flame retardant Increases coupling between resin and fiberglass, while having compatibility with epoxy | Solid |
| | | MW: 1500-2500 |
| | | Phenyl/methyl ratio: 100/0 |
| | | Silanol: 6% |
| | | SiO_{2:} 47% |
| Nanopox XP | Adhesion and Flame retardant | EEW: 260-300 g/eq |
| 22/0525 | Stronger epoxy resin | Viscosity: 10,000-30,000 cP @ 25°C |
| | Improves compressive strength and flame retarding, uniformly penetrating woven fibreglass | |
| | | Silica content: 40% by wt |
| | | Silica particle size: < 50 nanometers |
| TCP | Diluent | |
| | Viscosity reducer, fiber wetting, has some phosphorus content | |
| nonylphenol | Additive | |
| | Low viscosity, wetting agent &/or reaction catalyst | |
| Glymo | Additive | |
| | Adhesion promoter, enhanced resin coupling with fiberglass and silica filler | |
| AF-4 | Additive | |
| | wetting agent, defoamer | |

### Laminate Preparation

The glass cloth used had the following properties: style 1581 or 7781, 8-shaft satin weave, 57/54 warp/filling, a thickness of 0.008-0.012 for style 1581 or 0.008-0.011 for style 7781, and a Volan coating.

To determine the compressive strength, flammability and lap shear strength of a cured laminate made from curing compositions 1-6 with an amine hardener, the amine hardener was added to the compositions in a resin/hardener ratio of 100/13-15. Specifically, the resin/hardener ratio for compositions 1, 2 and 6 was 100/15, 100/13 for compositions 3 and 5 and 100/14 for composition 4.

### Compressive strength test

Compositions 1-6 were each used individually to produce laminates that were subsequently tested for compressive strength.

Twelve plies of glass cloth were cut to the appropriate dimensions. Compositions 1-6 were mixed with Epocast Hardener 9816 (supplied by Huntsman Advanced Materials Americas Inc.) in the resin/hardener ratios listed above. A 12-ply laminate was assembled by laying down one ply at a time, applying one of the compositions to the surface of the glass cloth, and then spreading the composition over the entire area. The next ply of glass cloth was placed on top of the first ply and the process above repeated until all 12 plies had been laid down. Another set of laminates was made using compositions 1-6 with Epocast Hardener 946 according to the protocol described above. The cured data reported in Table 7 is an average from the two laminate sets.

Initial curing was done in a vacuum bag in order to remove air and excess resin using 20 inches of vacuum bag pressure. Cure time in the vacuum bag was 16 to 24 hours. The laminate was removed from the vacuum bag and placed in a 25°C incubator for 7 days to complete the cure. The fiber content was verified at 67±3% by weight prior to testing.

The laminate was tested according to the Standard Test Method for Compressive Properties for Rigid Plastics (ASTM D695).

### Flammability test

Compositions 1-6 were each used individually to produce a laminate that was subsequently tested for flammability.

Two plies of glass cloth were cut to the appropriate dimensions. Compositions 1-6 were mixed with Epocast Hardener 9816 in the resin/hardener ratios listed above. The 2-ply laminate was assembled by laying down one ply, applying one of the compositions to the surface of the ply, spreading the composition over the entire area, and placing the second ply on top. Another set of laminates was made using compositions 1-6 with Epocast Hardener 946 according to the protocol described above. The cured data reported in Table 7 is an average from the two laminate sets.

Initial curing was done in a vacuum bag in order to remove air and excess resin using 20 inches of vacuum bag pressure. Cure time in the vacuum bag was 16 to 24 hours. The laminate was removed from the vacuum bag and placed in a 25°C incubator for 7 days to complete the cure. The fiber content was verified at 67±3% by weight prior to testing.

A determination of flammability properties for the 2-ply laminates was made by the 60-Second Vertical Ignition Test specified by the Boeing Company in BSS7230, which references CFR 25.853.

### Lap Shear Strength

Compositions 1, 2, 4 and 6 were used to prepare laminates that were subsequently tested for lap shear strength.

Compositions 1, 2, 4 and 6 were mixed with Epocast Hardener 9816 in the resin/hardener ratios listed above. Six-ply laminates were assembled by laying down one ply at a time, applying one of the compositions to the surface of the ply, and then spreading the composition over the entire area. The next ply of glass cloth was placed on top of the first ply and the process above repeated until all 6 plies had been laid down. This process of producing a laminate was repeated using each composition 1, 2, 4 and 6.

Initial curing was done in a vacuum bag in order to remove air and excess resin using 20 inches of vacuum bag pressure. Cure time in the vacuum bag was 16 to 24 hours. The laminate was removed from the vacuum bag and placed in a 25°C incubator for 7 days to complete the cure. The fiber content was verified at 67±3% by weight prior to testing.

To determine lap shear strength, the cured 6-ply laminate was bonded to another cured 6-ply laminate at room temperature, using as the bonding adhesive the same laminating resin that was used to prepare the laminates from compositions 1, 2, 4 and 6. The specimens were allowed to cure at room temperature and were measured for tensile shear strength, according to ASTM D1002, after temperature/humidity conditioning. Cohesive failure within the bonding layer or laminate is desired to indicate that the adhesive bond strength is higher than the cohesive strength of the cured laminating resin.

### TEST RESULTS

Table 6 shows the active components of Compositions 1-6. Table 7 shows the test results for Compositions 1-6. Unexpectedly superior test results include an uncured viscosity of less than 5000 cps, a laminate-compressive strength of greater than 45,000 psi following curing, and all cured compositions were transparent. Other desirable test results include certain flame properties such as self-extinction, a burn length of less than 4 inches, no drip, and low smoke emission.

As noted above, Composition 1 comprises pentabromodiphenylether as the flame retardant. It does not comprise phosphonate or siloxane components. Composition 2 comprises a phosphonate ester as the flame retardant. It does not comprise any halogenated flame retardant additives or siloxanes. Composition 3 comprises a siloxane as the flame retardant. It does not comprise a phosphonate ester or halogenated flame retardant additives. Composition 4 comprises both a phosphonate ester and a siloxane. It does not comprise a halogenated flame retardant additive. Composition 5 comprises silica nano particles. It does not contain a siloxane, a phosphonate, or a halogenated flame retardant additive. Composition 6 comprises both silica nano particles and a siloxane. It does not contain a phosphonate or a halogenated flame retardant additive.

**TABLE 6**

| Component | Composition 1 Control | Composition 2 | Composition 3 | Composition 4 | Composition 5 | Composition 6 |
|---|---|---|---|---|---|---|
| Total Epoxy | 62.0 | 62.0 | 63.75 | 65.75 | 59.3 | 68.06 |
| R-001 phosphonate | --- | 22.1 | --- | 12.0 | --- | --- |
| Nano-silica rom Nanopox KP 22/0525 | --- | --- | --- | --- | 24.8 | 13.68 |
| DE-71 (PBDE) | 22.10 | --- | --- | --- | --- | --- |
| 217 siloxane | --- | --- | 21.25 | 11.25 | --- | 3.66 |
| TCP | 15.00 | 15 | 14 | 10.00 | 15.0 | 13.6 |
| Other Additives | 0.9 | 0.9 | 1.0 | 1.0 | 0.9 | 1.0 |

**TABLE 7**

| Properties² | Composition 1 Control | Composition 2 | Composition 3 | Composition 4 | Composition 5 | Composition 6 |
|---|---|---|---|---|---|---|
| Viscosity @ 25°C (cP) | ∼ 4,000 | ∼ 6,000 | 1,000 | < 10,000 | ∼ 6,000 | < 5,000 |
| Compressive strength @ 25°C (psi), need >40,000 psi | > 50,000 | < 40,000 | 41,200 | 48,000 | < 30,000 | > 50,000 |
| Lap shear strength between cured laminates using laminating resin as adhesive | 1,600 (cohesive) | 1,800 (cohesive) | Not Tested | 1,750 (cohesive) | Not Tested | 1,750 (cohesive) |
| Flame properties: self-extinguishing (within less than 15 seconds) | Yes | Yes | Self extinguished but not within less than 15 seconds | Yes | Yes | Yes |
| Flame properties: burn length <4 Inches | Yes | Yes | No (between 4 and 8 inches) | Yes | Yes | Yes |
| Name properties: drip | None | None | None | None | None | None |

| | | | | | | |
|---|---|---|---|---|---|---|
| ² Viscosity is of the composition only. Compressive strength, lap shear strength and flammability properties are of the compositions cured with the amine hardener. | | | | | | |

## Claims

1. A curable fire retardant composition comprising:
(a) a monomer, oligomer or polymer, or any mixture thereof;
(b) a compatible siloxane; and
(c) optionally, an additional fire retardant additive.
wherein the composition is in liquid form at 25C,
and wherein component (a) is a mixture of epoxies selected from the group consisting of diglycidyl ethers of bisphenol A, hydrogenated bisphenol A, diglycidyl ethers of bisphenol F, hydrogenated bisphenol F, epoxy novolac, cycloaliphatic epoxies, and tri- and tetra-functional glycidyl functional tertiary amines.

2. The fire retardant composition of claim 1, wherein component (a) has a viscosity of less than 20,000 mPa · s at 25 C°, preferably less than 10,000 mPa · s, more preferably less than 5000 mPa · s, more preferably in the range 500-5000 mPa · s, most preferably in the range 1000-5000 mPa · s.

3. The fire retardant composition of any preceding claim, wherein component (a) is a mixture of epoxies and the mixture of epoxies comprises bisphenol A and bisphenol F.

4. The fire retardant composition of any preceding claim, wherein component (b) is hydroxy functional and/or is a polyphenylsiloxane.

5. The fire retardant composition of claim 4, wherein the hydroxy functional polyphenylsiloxane
(i) is at least 40 mol percent mono-substituted by phenyl or substituted phenyl groups; and
(ii) comprises 30 to 70 percent by weight of silicon hydroxyl dioxide and silanol hydroxy groups, preferably 50 percent by weight of silicon dioxide and silanol hydroxy groups.

6. The fire retardant composition of claim 4, wherein the hydroxy functional polyphenylsiloxane comprises
(i) 100 mol percent of monophenylsiloxane; and
(ii) 47 percent by weight of silicon dioxide and 6 percent by weight of silanol hydroxy groups.

7. The fire retardant composition of any preceding claim, wherein component (b) is oligomeric phenylsilsesquioxane.

8. The fire retardant composition of any preceding claim, wherein component (c) is present and is not a halogenated or an antimony compound, and preferably comprises:
(i) a phosphorus compound; or
(ii) silica nano particles.

9. The fire retardant composition of claim 8, wherein the phosphorous compound is a liquid organo phosphate or phosphonate compound, preferably a liquid phosphonate ester compound which preferably comprises greater than 20 percent by weight of phosphorus and greater than 50 percent by weight of phosphorus oxide and, more preferably comprises 40 to 85 percent by weight of component (a), 2 to 50 percent by weight of component (b), and up to 40 percent by weight of component (c).

10. The fire retardant composition of any preceding claim, further comprising a curing agent, preferably an amine hardener.

11. A method of producing a fire retardant composite comprising the steps of applying the fire retardant composition of any preceding claim to a substrate and curing or setting the composition and substrate to form a composite.

12. A cured composite produced by the process of claim 11.

13. Use of the composition of any of claim 1 to 10 to form laminating resins, adhesives, sealants, coatings, printed wiring boards, prepregs, composites with combustible or non combustible fibers such as glass fibers, Aluminium borate whiskers, granite fibers, textile and carbon fibers.

## Patentansprüche

1. Härtbare flammwidrige Zusammensetzung umfassend:
(a) ein Monomer, Oligomer oder Polymer, oder irgendeine Mischung davon;
(b) ein kompatibles Siloxan; und
(c) wahlweise ein zusätzliches flammwidriges Additiv,
worin die Zusammensetzung bei 25 °C in flüssiger Form vorliegt,
und worin die Komponente (a) eine Mischung aus Epoxy-Verbindungen darstellt, ausgewählt aus der Gruppe, bestehend aus Diglycidylethern von Bisphenol A, hydriertem Bisphenol A, Diglycidylethern von Bisphenol F, hydriertem Bisphenol F, Epoxynovolac, cycloaliphatischen Epoxy-Verbindungen und tri- und tetrafunktionellen Glycidyl-funktionellen tertiären Aminen.

2. Flammwidrige Zusammensetzung nach Anspruch 1, worin die Komponente (a) eine Viskosität von weniger als 20.000 mPa·s bei 25 °C, vorzugsweise weniger als 10.000 mPa·s, besonders bevorzugt weniger als 5.000 mPa·s, ganz besonders bevorzugt im Bereich von 500 bis 5.000 mPa·s, am meisten bevorzugt im Bereich von 1.000 bis 5.000 mPa·s aufweist.

3. Flammwidrige Zusammensetzung nach einem der vorangehenden Ansprüche, worin die Komponente (a) eine Mischung aus Epoxy-Verbindungen darstellt und die Mischung aus Epoxy-Verbindungen Bisphenol A und Bisphenol F umfasst.

4. Flammwidrige Zusammensetzung nach einem der vorangehenden Ansprüche, worin die Komponente (b) hydroxyfunktionell ist und/oder ein Polyphenylsiloxan ist.

5. Flammwidrige Zusammensetzung nach Anspruch 4, worin das hydroxyfunktionale Polyphenylsiloxan
(i) zu mindestens 40 Mol% durch Phenyl oder substituierte Phenylgruppen monosubstituiert ist; und
(ii) 30 bis 70 Gew.% Siliziumhydroxyldioxid und Silanolhydroxygruppen, vorzugsweise 50 Gew.% Siliziumdioxid und Silanolhydroxygruppen umfasst.

6. Flammwidrige Zusammensetzung nach Anspruch 4, worin das hydroxyfunktionale Polyphenylsiloxan umfasst
(i) 100 Mol% Monophenylsiloxan; und
(ii) 47 Gew.% Siliziumdioxid und 6 Gew.% Silanolhydroxygruppen.

7. Flammwidrige Zusammensetzung nach einem der vorangehenden Ansprüche, worin die Komponente (b) oligomeres Phenylsilsesquioxan ist.

8. Flammwidrige Zusammensetzung nach einem der vorangehenden Ansprüche, worin die Komponente (c) vorliegt und nicht halogeniert ist oder eine Antimonverbindung darstellt und vorzugsweise umfasst:
(i) eine Phosphorverbindung; oder
(ii) Silika-Nanoteilchen.

9. Flammwidrige Zusammensetzung nach Anspruch 8, worin die Phosphorverbindung eine flüssige Organophosphat- oder Phosphonatverbindung ist, vorzugsweise eine flüssige Phosphonatesterverbindung, die vorzugsweise mehr als 20 Gew.% Phosphor und mehr als 50 Gew.% Phosphoroxid umfasst und besonders bevorzugt 40 bis 85 Gew.% Komponente (a), 2 bis 50 Gew.% Komponente (b) und bis zu 40 Gew.% Komponente (c) umfasst.

10. Flammwidrige Zusammensetzung nach einem der vorangehenden Ansprüche, weiterhin umfassend ein Härtungsmittel, bevorzugt einen Amin-Aushärter.

11. Verfahren zur Herstellung eines flammwidrigen Komposits, umfassend die Schritte des Auftragens der flammwidrigen Zusammensetzung nach einem der vorangehenden Ansprüche auf ein Substrat und Aushärten und Abbinden der Zusammensetzung und des Substrats unter Bildung eines Komposits.

12. Gehärtetes Komposit, hergestellt durch das Verfahren nach Anspruch 11.

13. Verwendung der Zusammensetzung nach einem der Ansprüche 1 bis 10 zur Bildung von Laminierungsharzen, Haftmitteln, Versiegelungsmitteln, Beschichtungen, bedruckten Leiterplatten, Prepregs, Kompositen mit brennbaren oder nicht-brennbaren Fasern, wie Glasfasern, Aluminiumboratwhiskern, Granitfasern, Textil- und Kohlefasern.

## Revendications

1. Composition ignifuge durcissable comprenant :
(a) un monomère, oligomère ou polymère, ou tout mélange de ceux-ci ;
(b) un siloxane compatible ; et
(c) facultativement, un additif ignifuge supplémentaire,
dans laquelle la composition est dans une forme liquide à 25°C,
et dans laquelle le composant (a) est un mélange d'époxydes choisis dans le groupe consistant en diglycidyl éthers de bisphénol A, bisphénol A hydrogéné, diglycidyl éthers de bisphénol F, bisphénol F hydrogéné, époxy novolaque, époxydes cycloaliphatiques et amines tertiaires à fonctionnalités de glycidyle tri- et tétra-fonctionnelles.

2. Composition ignifuge selon la revendication 1, dans laquelle le composant (a) a une viscosité de moins de 20 000 m·Pas à 25°C, de préférence de moins de 10 000 m·Pas, de façon davantage préférée de moins de 5000 mPa·s, de façon davantage préférée dans la plage de 500-5000 mPa·s, de la façon que l'on préfère le plus dans la plage de 1000-5000 mPa·s.

3. Composition ignifuge selon l'une quelconque des revendications précédentes, dans laquelle le composant (a) est un mélange d'époxydes et le mélange d'époxydes comprend du bisphénol A et du bisphénol F.

4. Composition ignifuge selon l'une quelconque des revendications précédentes, dans laquelle le composant (b) est à fonctionnalité hydroxy et/ou est un polyphénylsiloxane.

5. Composition ignifuge selon la revendication 4, dans laquelle le polyphénylsiloxane à fonctionnalité hydroxy :
(i) est au moins à 40 pour cent en moles mono-substitué par des groupes phényle ou phényle substitué ; et
(ii) comprend 30 à 70 pour cent en poids de dioxyde de silicium hydroxylé et de groupes hydroxy de silanol, de préférence 50 pour cent en poids de dioxyde de silicium et de groupes hydroxy de silanol.

6. Composition ignifuge selon la revendication 4, dans laquelle le polyphénylsiloxane à fonctionnalité hydroxy comprend :
(i) 100 pour cent en moles de monophénylsiloxane ; et
(ii) 47 pour-cent en poids de dioxyde de silicium et 6 pour cent en poids de groupes hydroxy de silanol.

7. Composition ignifuge selon l'une quelconque des revendications précédentes, dans laquelle le composant (b) est un phénylsilsesquioxane oligomérique.

8. Composition ignifuge selon l'une quelconque des revendications précédentes, dans laquelle le composant (c) est présent et n'est pas un composé halogéné ou un composé de l'antimoine, et comprend de préférence :
(i) un composé du phosphore ; ou
(ii) des nano particules de silice.

9. Composition ignifuge selon la revendication 8, dans laquelle le composé du phosphore est un composé organo phosphate ou phosphonate liquide, de préférence un composé ester phosphonate liquide qui comprend de préférence plus de 20 pour cent en poids de phosphore et plus de 50 pour cent en poids d'oxyde de phosphore et, de façon davantage préférée, comprend 40 à 85 pour cent en poids de composant (a), 2 à 50 pour cent en poids de composant (b) et jusqu'à 40 pour cent en poids de composant (c).

10. Composition ignifuge selon l'une quelconque des revendications précédentes, comprenant de plus un agent de durcissement, de préférence un agent de durcissement amine.

11. Procédé de fabtication d'un composite ignifuge comprenant les étapes d'application de la composition ignifuge selon l'une quelconque des revendications précédentes sur un substrat et de durcissement ou de prise de la composition et du substrat pour former un composite.

12. Composite durci obtenu par le procédé selon la revendication 11.

13. Utilisation de la composition selon l'une quelconque des revendications 1 à 10 pour former des résines de stratification, des adhésifs, des produits de scellement, des revêtements, des cartes imprimées, des pré-imprégnés, des composites ayant des fibres combustibles ou non combustibles telles que des fibres de verre, des barbes de borate d'aluminium, des fibres de granite, des fibres textiles et de carbone.
